# EUROPEAN PATENT SPECIFICATION

(11) **EP 2 389 693 B1**
(45) Date of publication and mention of the grant of the patent: **15.02.2017**
(21) Application number: 09838929.9
(22) Date of filing: 09.12.2009
(51) Int. Cl.: H01L 33/20, H01L 33/02, H01L 33/00, H01L 33/10, H01L 33/22

(54) **Light emitting diode device and method for manufacturing the same**
Leuchtdioden-Bauelement und dessen Herstellungsverfahren
Dispositif de diode électroluminescente et son procédé de fabrication

(30) Priority: 21.01.2009 KR 20090005037
(43) Date of publication of application: 30.11.2011
(73) Proprietor: LG Siltron Inc., Gumi, Gyeongsanbuk-do 730-350 (KR)
(72) Inventor: LEE, Ho-Jun, Daegu 700-444 (KR); LEE, Dong-Kun, Gumi-si, Gyeongbuk 730-748 (KR); KIM, Yong-Jin, Gumi-si Gyeongbuk 730-787 (KR); KIM, Doo-Soo, Chilgok-gun Gyeongbuk 718-805 (KR)
(74) Representative: Patentanwälte Bauer Vorberg Kayser
(86) International application number: PCT/KR2009/007333
(87) International publication number: WO 2010/085042

(56) References cited:
- EP-A2- 1 921 668
- DE-A1-102007 004 302
- KR-A- 20060 121 432
- US-A1- 2006 223 211
- US-A1- 2007 166 862
- US-A1- 2007 166 862
- US-A1- 2007 181 889
- US-A1- 2009 001 398

## Description

### Technical Field

The embodiment relates to a light emitting diode device and a method for manufacturing the same.

### Background Art

Nitride gallium (GaN) is generally known as a compound semiconductor material suitable for blue light emitting devices or high-temperature electronic devices. Recently, the blue light emitting devices have been extensively used, so demands for GaN substrates have been increased. However, high-quality GaN substrates may not be easily manufactured, so that the manufacturing cost and the manufacturing time for the GaN substrates may be increased.

Different from silicon or sapphire, the GaN cannot be grown in the form of an ingot, so an epitaxial growth method is adopted to grow the GaN on a heterogeneous substrate, such as a SiC substrate or a sapphire substrate. Since there is difference in lattice constant and thermal expansion coefficient between the heterogeneous substrate and GaN crystal, dislocation density becomes high so that characteristics of devices employing the GaN substrate may be degraded and various problems may occur when manufacturing the devices.

In order to reduce the problems, the manufacturing process is complicated and the manufacturing time is increased. In the case of the ELO (epitaxial lateral overgrowth), which is extensively used to manufacture the high-quality GaN substrate, the stress caused by difference in lattice constant and thermal expansion coefficient between the substrate and GaN crystal is blocked by using a SiO₂ mask having a stripe pattern. That is, according to the ELO scheme, after growing the GaN layer on the substrate, the substrate having the GaN layer is unloaded from a reactor and then the substrate is loaded into deposition equipment to deposit a SiO₂ layer on the GaN layer. Then, the substrate having the SiO₂ layer is unloaded from the deposition equipment and a SiO₂ mask pattern is formed on the substrate through a photolithography process. Then, the substrate is again loaded into the reactor to complete the formation of the GaN layer (see Korean Patent Publication No. 455277). However, such an ELO scheme is very complicated, so that the process time is lengthened and reproducibility and the product yield are lowered.

Meanwhile, the light emitting device employing the compound semiconductor must have improved light emitting efficiency. That is, light emitted from an active layer of the light emitting device is guided toward a surface of the light emitting device as well as the substrate, so that the light is absorbed in the substrate, resulting in degradation of the light emitting efficiency. In order to solve this problem, a patterned sapphire substrate having a fine surface is employed to reflect the light guided toward the substrate from the active layer such that that the amount of light absorbed in or passing through the substrate can be reduced while increasing the amount of light guided toward the surface of the light emitting device. A concave-convex structure is formed on the sapphire substrate by performing a photolithography process with respect to the surface of the sapphire substrate, such that that the light guided toward the substrate from the active layer is reflected toward the surface of the light emitting device due to the difference in a refractive index between GaN and sapphire and the surficial structure of the substrate. However, in order to form fine patterns on the sapphire substrate, a complicated photolithography process must be performed so that much time is spent. In addition, since the angle of a concave-convex pattern is changed according to the degree of etching of the sapphire substrate, a GaN layer is not uniformly grown on the sapphire substrate through the epitaxial process. Accordingly, deviation occurs in the optical characteristic of the light emitting device.

Instead of the SiC substrate and the sapphire substrate, a low-priced silicon wafer having a large diameter can be used as a support substrate for the GaN growth. However, since greater difference is made in lattice constant and thermal expansion coefficient between the silicon substrate and the GaN crystal, the high-quality GaN substrate may not be obtained. In addition, the light emitted from the active layer of the light emitting device is absorbed in the silicon substrate due to the low band gap energy and opaque property of the silicon, so that the light emitting efficiency may be lowered.

As mentioned above, expensive and complicated processes, such as the photolithography process, are required to manufacture the high-quality compound semiconductor substrate having reduced crystal defect. In addition, in order to improve the light emitting efficiency and reduce power consumption, the high-cost processes are required. However, even though the high-cost processes are performed, the reproducibility and the product yield are still US2009/0001398 A1 discloses a semiconductor light emitting diode device including a silica particle layer.

### Disclosure of Invention

### Technical Problem

The embodiment provides a semiconductor device and a light emitting device which can be easily produced and have high quality and high efficiency and a method for manufacturing the same.

### Solution to Problem

According to the embodiment, the semiconductor device includes a substrate, a plurality of rods disposed on the substrate, a plurality of particles disposed between the rods and on the substrate, and a first semiconductor layer disposed on the rods.

According to the embodiment, the light emitting device includes a substrate, a plurality of rods disposed on the substrate, a plurality of particles disposed between the rods and on the substrate, a first conductive-type semiconductor layer disposed on the particles and the rods, an active layer disposed on the first conductive-type semiconductor layer, and a second conductive-type semiconductor layer disposed on the active layer.

According to the embodiment, the method for manufacturing a semiconductor device includes preparing a substrate, disposing a plurality of first particles on the substrate, and forming a plurality of rods by etching a portion of the substrate by using the first particles as an etch mask.

### Advantageous Effects of Invention

According to the method for manufacturing the semiconductor device of the embodiment, the substrate is etched by using the first particles as a mask, thereby forming a plurality of rods. In other words, according to the method for manufacturing the semiconductor device of the embodiment, the plural rods are formed by patterning the substrate without using a mask formed through a photolithography process.

Therefore, when comparing with an existing epitaxial lateral overgrowth (ELO) scheme using a photolithography process or a scheme of employing a sapphire substrate finely patterned through a photolithography process, a high-quality semiconductor device can be easily manufactured through the method for manufacturing the semiconductor device according to the embodiment. In other words, the manufacturing process of the semiconductor device according to the embodiment is easily controlled, and performed at low cost with high reproducibility and high product yield.

In addition, the semiconductor device and the light emitting device according to the embodiment include a plurality of particles interposed between rods. The light efficiency of the semiconductor device and the light emitting device according to the embodiment can be improved due to difference in a refractive index between the first semiconductor layer or the first conductive-type semiconductor layer and the particles.

Light emitted from the light emitting layer such as the active layer is reflected in an upward direction from the interfacial surface between the first semiconductor layer or the first conductive-type semiconductor layer and the particles. Accordingly, the light efficiency of the semiconductor device and the light emitting device according to the embodiment can be improved.

Since a small contact area is formed between the first semiconductor layer or the first conductive-type semiconductor layer and the rods, defects caused by crystallographic difference between the first semiconductor layer or the first conductive-type semiconductor layer and the rods can be reduced. Similarly, defects caused by crystallographic difference between the rods and the substrate can be reduced.

Accordingly, the rods can serve as a buffer to compensate for the crystallographic difference between the first semiconductor layer or the first conductive-type semiconductor layer and the substrate.

Therefore, the semiconductor device and the light emitting device according to the embodiment can reduce defects caused by crystallographic difference between layers.

### Brief Description of Drawings

FIGS. 1A to 5 are views showing the manufacturing process of a semiconductor light emitting device according to an embodiment;
FIGs. 6A and 6B are SEM photographs obtained by photographing rods of a semiconductor light device when a process of FIG. 2 has been finished and the first particles has been removed;
FIGs. 7A and 7B are SEM photographs obtained by photographing rods and particles when a process of FIG. 3 has been finished; and
FIG. 8 is a view showing a portion of the manufacturing process of a semiconductor light emitting device according to another embodiment.

### Mode for the Invention

In the description of an embodiment, it will be understood that when a substrate, a rod, a layer, a particle or an electrode is referred to being "on" or "under" another substrate, another rod, another layer, another particle or another electrode, it can be "directly" or "indirectly" on the other substrate, rod, layer, particle or electrode, or one or more intervening substrate, rod, layer, particle or electrode may be also be present. Further, the meaning of "on" or "region" must be determined based on the accompanying drawings. The thickness and size of some components shown in the drawings can be exaggerated. In addition, the size of each component does not utterly reflect an actual size.

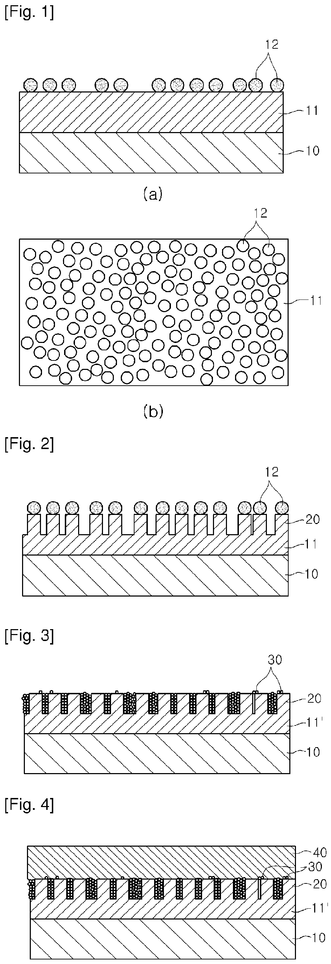

FIGS. 1A to 5 are views showing the manufacturing process of a semiconductor light emitting device according to an embodiment. FIG. 1A and FIGS. 2 to 5 are sectional views, and FIG. 1B is a plan view, in which plan views are omitted in FIGS. 2 to 5.

Referring to FIGS. 1A and 1B, a first compound semiconductor layer 11 is grown on a support substrate 10, and first particles 12 are coated on the first compound semiconductor layer 11.

The support substrate 10 may include sapphire (Al₂O₃), GaAs, spinel, InP, SiC, or Si. Since the above materials have the following advantages and disadvantages, the materials are properly selected according to application fields or required quality. The sapphire substrate has superior high-temperature stability, but has a small size, so that it is not suitable for manufacturing a large-size semiconductor device. The SiC substrate has a crystalline structure identical to that of the GaN substrate which is a representative nitride semiconductor. The SiC substrate has superior high-temperature stability. In addition, the SiC substrate has a lattice constant and a thermal expansion coefficient similar to those of the GaN substrate, but is expensive. The Si substrate can be used for manufacturing the semiconductor device having a large size of 12-inches or more, so that the manufacturing cost can be reduced and the semiconductor device suitable for various applications can be manufactured. The Si substrate represents relatively greater difference in a lattice constant or a thermal expansion coefficient with respect to the GaN substrate.

Semiconductor rods 20 that are described later are formed by the first compound semiconductor layer 11 that has been grown on the support substrate 10. In this case, the first compound semiconductor layer 11 may include a material identical to or similar to that of a semiconductor layer formed on the semiconductor rods 20. The first compound semiconductor layer 11 of FIG. 1A or 1B and a compound semiconductor layer 40 of FIG. 4 may be actually grown in the same method. Accordingly, a method for growing the compound semiconductor layer 40 of FIG. 4 can be realized based on a method for growing the first compound semiconductor layer 11 of FIG. 1A.

First, although not shown, a buffer layer may be formed to reduce crystallographic difference between the first support substrate 10 and the first compound semiconductor layer 11, so that a crystalline defect density can be minimized. Since the buffer layer has a crystalline characteristic similar to that of the first compound semiconductor layer 11, the buffer layer preferably includes a material that is chemically stabilized. In other words, preferably, the buffer layer may include a material identical to or similar to that of the first compound semiconductor layer 11 in terms of a crystalline structure, a lattice constant, or a thermal expansion coefficient. More preferably, the buffer layer includes the material having the crystal structure identical to that of a compound semiconductor layer, which is formed through the subsequent process, and representing difference in lattice constant relative to the compound semiconductor layer within a range of 20%.

In more detail, when the first compound semiconductor layer 11 includes a nitride-based compound semiconductor, the buffer layer may be prepared as a single layer or a multiple layer by using a GaN layer, an AlN layer, an AlGaN layer and a combination thereof. In general, the buffer layer is formed through an MOCVD (metal organic chemical vapor deposition), in which reactive precursors are injected into a reactor through individual lines at a predetermined flow rate and the reactor is maintained with predetermined pressure and temperature such that the reactive precursors are subject to chemical reaction, thereby forming the buffer layer having desired thickness. In this case, the reactive precursors may include trimethyl aluminum (TMA1), trimethyl gallium (TMGa), triethyl gallium (TEGa) or GaCL₃. In addition, ammonia (NH₃), nitrogen, or tertiarybutylamine (N(C₄H₉)H₂) can be used as nitride source gas. The low-temperature GaN buffer layer is grown at the temperature range of about 400°C to about 800°C until the low-temperature GaN buffer layer has the thickness of about 10 to 40nm. The AlN buffer layer or AlGaN buffer layer is grown at the temperature range of about 400°C to 1200°C until the AlN buffer layer or AlGaN buffer layer has the thickness of about 10 nm to about 200nm. The buffer layers can be selectively used according to the support substrate, growth equipment (MOCVD equipment), and growth conditions.

Then, the first compound semiconductor layer 11 is grown on the support substrate formed with the buffer layer. The first compound semiconductor layer 11 may include the III-V group compound semiconductor or the II-VI group compound semiconductor, which can emit light of ultraviolet band, visible band or infrared band. If the nitride-based compound semiconductor is used for the first compound semiconductor layer 11, GaN, InN, AlN, InGaN, AlGaN, AlInN, or AlInGaN (expressed as Al_{X}In_{Y}Ga_{Z}N, wherein 0=X=1, 0=Y=1 and 0=Z=1) may be used. The GaN is a direct-transition type wide band gap semiconductor having band gap energy of 3.4eV and is known as a material suitable for a blue light emitting device or a high-temperature electronic device. When the first compound semiconductor layer 11 is deposited, indium (In) and aluminum (Al) are individually, simultaneously, or sequentially injected to grow an InN layer, an AlN layer, an InGaN layer, an AlGaN layer, an AlInN layer, or an AlInGaN layer such that the band gap of the device can be adjusted in the range of 1.9 to 6.2eV. The GaN layer has the band gap of 3.4eV, the AlN layer has the band gap of 6.2eV, and the InN layer has the band gap of 0.7eV. Since the AlN layer has the band gap of 6.2eV, the AlN can emit light of the ultraviolet band. Although the Al_{X}Ga₁₋ₓN layer (0<x<1) has the band gap smaller than that of the AlN layer, the Al_{X}Ga₁₋ₓN layer can emit the light of the ultraviolet band. The GaN layer has the band gap of 3.4eV smaller than that of the Al_{X}Ga₁₋ₓN layer (0<x<1), and the In_{Y}Ga ₁₋ₓN layer (0<x<1) has the band gap smaller than that of the GaN layer and emits the light of the visible band. The InN layer has the band gap of 0.7eV smaller than that of the In_{Y}Ga₁₋ₓN layer (0<x<1) and emits the light of the infrared band.

Preferably, the first compound semiconductor layer 11 may be grown through a MOCVD scheme, an MBE (molecular beam epitaxy) scheme, or a HVPE (hybrid vapor phase epitaxy) scheme.

Hereinafter, a method for forming the first compound semiconductor layer 11 through the MOCVD scheme will be described. According to the MOCVD scheme, the substrate 10 is loaded into a reactor, and reactive precursors are introduced into the reactor by carrier gas. Thereafter, the first compound semiconductor layer 11 is grown by making the precursors to react with each other under predetermined temperature and pressure. When the compound semiconductor layer is a nitride-based thin film, the precursor includes TMA1, TMGa, TEGa, or GaCl₃. The nitride source gas includes NH ₃, nitrogen, or N(C₄H₉)H₂(Tertiarybutylamine). Preferably, the temperature of the reactor is in the range of about 900°C to about 1150°C, and the pressure of the reactor is in the range of 10⁻⁵ mmHg to about 2000mmHg.

The procedure for forming the GaN layer through the MOCVD scheme can be expressed by the following reaction formula 1.

(Reaction formula 1) Ga(CH₃)₃ + NN₃ → Ga(CH₃)₃·NH₃

TEGa and NH₃ are applied into the reactor so that Ga(CH₃)₃·NH₃ is generated.

Ga(CH₃)₃·NH₃ is thermally decomposed on the substrate 10, so that the GaN thin film is formed according to the following reaction formula 2.

(Reaction formula 2) Ga(CH₃)₃·NH₃ → GaN + nCH₄ + 1/2(3-n)H₂

The first compound semiconductor layer 11 is grown the form of a cluster or an island on the buffer layer, so that the first compound semiconductor layer 11 is absorbed in the substrate (buffer layer). Finally, the first compound semiconductor layer 11 is grown in the form of a planar layer.

If the first compound semiconductor layer 11 has been grown to a required thickness, the substrate 10 is unloaded from the reactor. Then, the first particles 12, which are previously prepared, are coated on the first compound semiconductor layer 11.

The first particles 12 may include balls having spherical shapes. The first particles 12 can be prepared by using various materials, such as SiO₂, Al₂O₃, TiO₂, ZrO₂, Y₂O₃-ZrO₂ , CuO, Cu₂O, Ta₂O₅, PZT(Pb(Zr, Ti)O₃), Nb₂O₅, FeSO₄, Fe₃O₄, Fe₂O₃, Na₂SO₄, GeO₂ and CdS. In addition, the size (diameter) of each first particle 12 can be variously selected within the range of few nanometer(nm) to tens of micrometer(µm) according to the type and the size of the compound semiconductor device. In general, the GaN layer formed on the GaN substrate used for the light emitting device has the thickness of few micrometer(µm), so the ball preferably has the size of 10nm to 2µm. In addition, the SiO ₂ ball is preferably used as the first particle 12 because the SiO₂ ball can be conveniently coated on and removed from the first compound semiconductor layer 11.

The SiO₂ ball is prepared as follows. First, TEOS (tetraethyl orthosilicate) is dissolved in ethanol absolute to make a first solution. In addition, an ammonia ethanol solution and deionized water are mixed with ethanol to make a second solution. The ammonia serves as a catalyst to form the particles. Then, the first solution is mixed with the second solution, and the mixed solution is stirred for a predetermined time under the predetermined temperature, thereby forming the spherical SiO₂ ball. Then, the solution containing the particles is subject to centrifugal separation, so that the particles are separated from the solution. The particles are cleaned by ethanol and the cleaned particles are dispersed into the ethanol solution, thereby obtaining the solution containing the particles similar to slurry. The size of the particle can be adjusted according to manufacturing conditions, such as the reaction time, temperature, and amount of reactive materials. Meanwhile, applicant of the subject application has suggested "a method for growing a compound semiconductor layer on a substrate coated with particles" (Korean Patent application No. 10-2005-0019605 filed in March 9, 2005 and Korean unexamined patent publication No. 10-2006-0098977 laid open in September 19, 2006). The method for manufacturing the SiO₂ ball is disclosed in the above application in detail.

The first particles 12 are coated on the first compound semiconductor layer 11 by dropping, dipping, spin-coating, or the like a solution containing the first particles 12. The density of the first particles 12 can be variously adjusted by appropriately controlling the coating time and the coating frequency. Preferably, as shown in FIGS. 1A and 1B, the first particles 12 are not densely coated on the first compound semiconductor layer 11 such that the first particles 12 properly expose the first compound semiconductor layer 11. As described below, the semiconductor rods 20 are formed by using the first particles 12, and second particles 30 are filled with a diameter smaller than that of the first particles 12 between the first particles 12. If the first particles 12 are excessively densely coated, the space in which the second particles 30 are filled may be reduced. The second particles 30 upwardly reflect light generated from an active layer 52, which is described later, and emitted to the support substrate 10. In order to increase an amount of the light, a predetermined area must be ensured between the first particles 12. Meanwhile, if the first particles 12 are excessively sparsely coated, time to grow the compound semiconductor layer 40 from an exposed surface of the semiconductor rods 20 is excessively prolonged. Therefore, the coating density of the first particles 20 is adjusted by taking into the light emitting efficiency of the light emitting device and the growing speed of the compound semiconductor layer 40. For example, when the compound semiconductor substrate according to the present invention is adapted to the light emitting device, the interval between the first particles 12 are preferably in the range of 0µm to 10µm. In contrast, the first particles 12 are combined with each other.

Then, as shown in FIG. 2, the first compound semiconductor layer 11 is etched by using the first particles 12 as an etch mask. The semiconductor rods 20 are formed on the support substrate 10. In more detail, the semiconductor rods 20 may have a cylindrical shape. In addition, the semiconductor rods 20 may have column shape. That is, the semiconductor rod 20 forms a semiconductor column.

In other words, the first compound semiconductor layer may be patterned by using the first particles 12 as an etch mask instead of a photolithography process employing a high-price photomask. In detail, the first particles 12 are used, so that the semiconductor rods 20 having the coating density and the diameter the same as those of the first particles 12 can be simply and economically formed. For example, the semiconductor rods 20 may have a diameter in the range of about 0.5µm to about 5µm.

A dry etching is preferably employed as the etching scheme because the dry etching represents superior etching anisotropy. In detail, RIE (reactive ion etching) or plasma etching, such as ICP (inductively coupled plasma) and TCP (transformer coupled plasma), can be employed. Typical etching gas suitable for the material of the first compound semiconductor layer 11 may be used. For instance, BCl₃ or Cl₂ can be used as the etching gas if the first compound semiconductor layer 11 includes the GaN. In addition, process conditions, such as the etching time, process pressure and temperature, are determined by taking into consideration the etching method, etching depth and etching rate according to the height of the semiconductor rods 20. The semiconductor rods 20 may have the height of about 0.5µm to about 5.0µm, but the embodiment is not limited thereto.

The first compound semiconductor layer 11 is etched shallower than the thickness of the first compound semiconductor layer 11. Accordingly, the first compound semiconductor layer 11 is etched such that the top surface of the support substrate 10 is not exposed. The semiconductor rods 20 are integrated with a remaining first compound semiconductor 11'. In other words, the semiconductor rods 20 make contact with the support substrate 10 through the remaining first compound semiconductor layer 11'.

In contrast, the first compound semiconductor layer 11 may be etched such that the top surface of the support substrate 10 is etched, thereby forming semiconductor rods.

The particles 12 can be randomly arranged on the first compound semiconductor layer 11. In other words, the particles 12 may be irregularly arranged on the first compound semiconductor layer 11. In this case, the semiconductor rods 20 are also randomly formed. The semiconductor rods 20 are randomly formed on the substrate 10. That is, the semiconductor rods 20 are spaced apart from each other at irregular intervals. In addition, the position, the number and/or the shape of the semiconductor rods 20 may vary in the semiconductor light emitting device according to the embodiment.

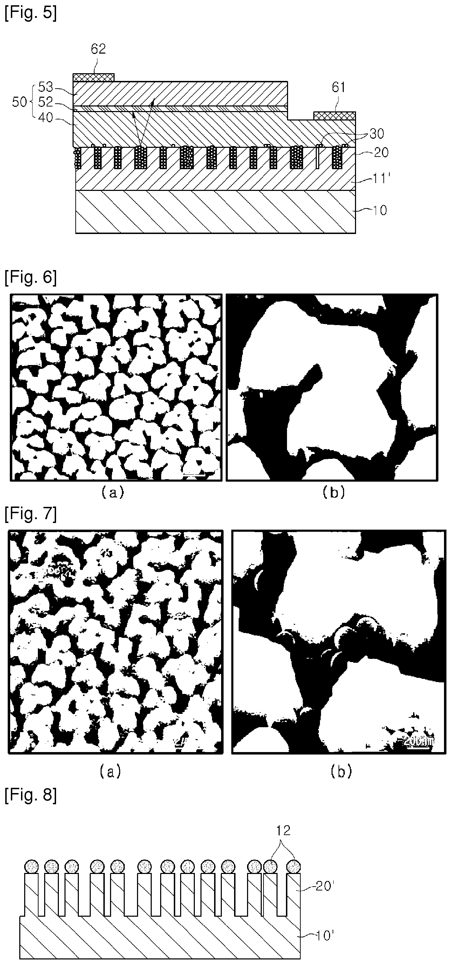

FIGs. 6A and 6B are SEM photographs obtained by photographing rods of a semiconductor light device when a process of FIG. 2 has been finished and the first particles has been removed.

Referring to FIGS. 6A and 6B, a region of the first compound semiconductor layer 11 coated with the first particles 12 is not etched. Accordingly, only the first compound semiconductor layer 11 exposed between the first particles 12 is etched. After the semiconductor rods 20 are formed as described above, the first particles 12 may be simply removed from the semiconductor rods 20 through an ultrasonic cleaning scheme or the like because the adhesive strength of the first particles 12 and the semiconductor rods 20 is not great. In addition, the first particles 12 may be removed through a chemical etching scheme. For example, if the first particles 12 include SiO₂, the first particles 12 are dipped into an HF solution, so that the first particles 12 may be removed through wet etching.

In addition, as shown in FIG. 8, the first compound semiconductor layer 11 is omitted, and semiconductor rods 20' may be directly formed on a support substrate 10'. In detail, after coating the first particles 12 on the support substrate 10', the support substrate 10' is etched with a predetermined depth by using the first particles 12 as an etch mask. Accordingly, the semiconductor rods 20' including a material identical to that of the support substrate 10' are formed. The support substrate 10' may be etched under etching process conditions identical to those of the first semiconductor layer 11.

Meanwhile, the semiconductor rods 20' are formed through various etching processes according to the type of materials of the support substrate 10'. For example, if the support substrate 10' includes silicon, etching gas, SF₆ or C₄F₈, may be used.

Although the embodiment has been described in that the first particles 12 are removed after the semiconductor rods 20 have been formed, the subsequent process can be performed without removing the first particles 12.

Thereafter, second particles 30 having a diameter smaller than that of the first particles 12 are coated on the support substrate 10 and between the semiconductor rods 20. In detail, the second particles 30 are filled between the semiconductor rods 20. The second particles 30 may be coated in the same coating scheme as that of the first particles 12.

In other words, even though the second particles 30 have a size different from that of the first particles 12, the second particles 30 may include materials the same as those of the first particles 12, and can be formed and coated through methods the same as those of the first particles 12. Therefore, description about the materials and the methods for forming and coating the second particles 30 will be omitted in order to avoid redundancy.

The size of the second particles 30 is smaller than the interval between the semiconductor rods 20 such that the second particles 30 are filled between the semiconductor rods 20. Preferably, the second particles 30 have a diameter in the range of about 10nm to about 500nm. More preferably, the second particles 30 have a diameter in the range of about 10nm to about 300nm. The second particles 30 may have various diameters within the above range. In addition, the first particles 12 may have various diameters with the above range.

FIGs. 7A and 7B are SEM photographs obtained by photographing rods and particles when a process of FIG. 3 has been finished.

Referring to FIGS. 7A and 7B, the second particles 30 are uniformly filled between the second rods 20. A portion of the second particles 30 may be arranged on the top surface of the semiconductor rods 20. As described above, since an amount of the second particles 30 that has been arranged on the top surface of the semiconductor rods 20 is slight, this does not exert an influence on the whole performance of the semiconductor light emitting device.

Meanwhile, the height of the second particles 30 filled between the semiconductor rods 20 is not restricted. However, as described below, the second particles 30 filled between the semiconductor rods 20 may have a predetermined height higher than the height of the double layer of the second particles 30 to serve as a reflective layer. In addition, the height of the second particles 30 may be lower than the height of the semiconductor rods 20 such that a compound semiconductor layer is smoothly grown from the exposed surface of the semiconductor rods 20. Although the second particles 30 are filled between the semiconductor rods 20 at the same height as that of the semiconductor rods 20 as shown in FIG. 3, the second particles 30 may be filled at the height corresponding to a half of the height of the semiconductor rods 20.

Thereafter, as shown in FIG. 4, after the second particles 30 have been filled between the semiconductor rods 20, the second compound semiconductor layer 40 is grown from the exposed surface of the semiconductor rods 20. The second compound semiconductor layer 40 may be formed through a MOCVD scheme similarly to the first compound semiconductor layer 11. Different from the first compound semiconductor layer 11 grown from the entire surface of the support substrate 10, the second compound semiconductor layer 40 is grown from the semiconductor rods 20 exposed between the second particles 30. Accordingly, the second compound semiconductor layer 40 is grown through an ELO scheme or PE (Pendo-Epitaxy) grown mechanism. If the second particles 30 are filled at a height lower than that of the semiconductor rods 20, the second compound semiconductor layer 40 is grown from the top surface and the side surface of the semiconductor rods 20. In addition, the second compound semiconductor layer 40 is grown while expanding into the entire surface of the support substrate 10.

Since the second compound semiconductor layer 40 is not grown from the second particles 30, a porous layer is formed between the second particles 30 and the second compound semiconductor layer 40. The porous layer easily reflects light emitted from the active layer 52 in an upward direction. For example, since the refractive index of the porous layer may be lower than that of the second compound semiconductor layer 40, a total internal reflection may easily occur on the interfacial surface between the porous layer and the second compound semiconductor layer 40.

The light emitted from the active layer 52 is effectively reflected in an upward direction by the particles 30. Further, the light is more easily reflected by the porous layer.

Accordingly, the semiconductor light emitting device according to the embodiment may have improved light emitting efficiency.

According to the embodiment, the second compound semiconductor layer 40 may have various configurations. For instance, the second compound semiconductor layer 40 can be prepared as a single-layer structure by using the same material, or a multilayer structure by using different materials. In addition, when the compound semiconductor layer 40 is deposited, at least one material selected from the group consisting of Si, Ge, Mg, Zn, O, Se, Mn, Ti, Ni and Fe is injected according to the use of the second compound semiconductor layer 40 such that the compound semiconductor layer may have a heterogeneous material as a dopant. The user can selectively add the heterogeneous material through in-situ doping, ex-situ doping or ion implantation in order to change the electrical, optical or magnetic characteristics of the compound semiconductor layer. According to the in-situ doping, the heterogeneous material is added when the semiconductor layer is grown. According to the ex-situ doping, the heterogeneous material is injected into the compound semiconductor layer through the heat treatment or plasma treatment after the compound semiconductor layer has been grown. According to the ion implantation, the heterogeneous material is accelerated to collide with the compound semiconductor layer, so that the heterogeneous material is injected into the semiconductor layer.

In addition, after the compound semiconductor layer has been formed according to the embodiment, a thicker compound semiconductor layer can be deposited through the HVPE (hydride vapor phase epitaxy) scheme by employing the compound semiconductor layer as a substrate. The HVPE scheme is a kind of vapor phase growth schemes, in which gas is supplied onto a substrate to grow crystal on the substrate through gas reaction. If the thicker compound semiconductor layer is formed through the HVPE scheme, the high-quality compound semiconductor layer uniformly grown on the substrate can be selectively used by separating the substrate from the compound semiconductor layer or removing the substrate through polishing or etching.

In order to form the thicker compound semiconductor layer, that is, the thicker GaN layer on the compound semiconductor layer through the HVPE scheme, a container having Ga metal therein is loaded into a reactor and the container is heated by a heater installed around the reactor, thereby making a Ga solution. The Ga solution reacts with HCl, thereby generating GaCl gas as expressed in the following reaction formula 3.

(Reaction formula 3) Ga(l)+HCL(g) → GaCl(g)+1/2H₂(g)

If the GaCl gas reacts with the NH₃, the GaN layer is formed according to the following reaction formula 4.

(Reaction formula 4) GaCl(g)+NH₃ → GaN+HCl(g)+H₂

At this time, non-reacted gas is exhausted according to the following reaction formula 5.

(Reaction formula 5) HCl(g)+NH₃ → NH₄Cl(g)

The HVPE scheme can grow the thicker layer at the growth rate of 100µm/hr, so the productivity can be improved.

Referring to FIG. 5, the active layer 52 and a second conductive-type compound semiconductor layer 53 are formed on the second compound semiconductor layer 40. According to the present embodiment, the second compound semiconductor layer 40 may be a first conductive-type semiconductor layer. In this case, the first conductive type refers to an N type, and the second conductive type refers to a P type. The semiconductor light emitting device according to the present embodiment is a light emitting diode having the structure of an N type layer, an active layer, and a P type layer.

In addition, the second compound semiconductor layer 40 may have the structure of an N-type layer, an active layer, and a P-type layer. The first conductive-type compound semiconductor layer is individually formed on the second compound semiconductor layer 40, and then the active layer and the second conductive-type compound semiconductor layer may be further formed on the resultant structure.

The second compound semiconductor layer 40 may include an n-GaN layer, and the second conductive-type compound semiconductor layer 53 may include a p-GaN layer. The active layer 52 may be an InGaN layer and may have a quantum well structure or a multiple quantum well structure.

Then, portions of the second conducive compound semiconductor layer 53, the active layer 52, and the second compound semiconductor layer 40 are sequentially patterned, and exposed portions of the particles 12 and the semiconductor rods 20 are etched to expose a portion of the metal layer.

Thereafter, a conductive material is deposited on the first compound semiconductor layer 40 and the resultant structure is patterned, thereby forming a first electrode 61. A second electrode 62 is formed on the second conductive-type compound semiconductor layer 53. The conductive material may include metal (e.g., Ni or Au), the alloy thereof, or transparent metal oxide (ITO) extensively used as an electrode of a light emitting device.

The semiconductor rods 20 are arranged on the substrate 10. The semiconductor rods 20 are spaced apart from each other.

The second particles 30 are disposed on the substrate 10, and between the semiconductor rods 20.

The second compound semiconductor layer 40 is provided between the semiconductor rods 20 and on an upper portion of the semiconductor rods 20. The second compound semiconductor layer 40 is doped with first conductive-type dopants. The second compound semiconductor layer 40 may be realized as an N-type semiconductor layer. The N-type semiconductor layer may include III-V group compounds. The N-type semiconductor layer may be realized by using a semiconductor material having a composition formula of InₓAl_{y}Ga_{1-x-y}N (0=x=1, 0=y=1, 0=x+y=1). The N-type semiconductor layer may include at least one of GaN, InN, AlN, InGaN, AlGaN, InAlGaN, and AlInN. The first conductive-type dopant is an N-type dopant, and the N-type dopant includes Si, Ge or Sn.

The active layer 52 is formed on the second compound semiconductor layer 40. The active layer 52 has a single quantum well structure or a multi-quantum well structure. The active layer 52 may be formed with the arrangement of an InGaN well layer and an AlGaN barrier layer or the arrangement of an InGaN well layer and a GaN barrier layer. The light emitting material of the active layer 52 may be varied according to light emitting wavelengths such as a blue wavelength, a red wavelength, or a green wavelength.

A conductive clad layer may be formed over and/or under the active layer 52. The conductive clad layer may be realized by using an AlGaN layer.

The second conductive-type semiconductor layer 53 may be formed on the active layer 52. The second conductive-type compound semiconductor layer 53 is doped with a second conductive-type dopant. In addition, the second electrode 52 makes contact with the top surface of the second conductive-type compound semiconductor layer 53. The second conductive-type compound semiconductor layer 53 may include a P-type semiconductor layer. The P-type semiconductor layer includes II-V group compounds. For example, the P-type semiconductor layer may be realized by using a semiconductor material having a composition formula of InₓAlyGa_{1-x-y}N (0=x=1, 0=y=1, 0=x+y=1). The P-type semiconductor layer may include GaN, InN, AlN, InGaN, AlGaN, InAlGaN or AlInN. The second conductive-type dopant is a P-type dopant, and the P-type dopant may include II-group elements such as Mg, Zn, Ca, Sr, and Ba.

The second compound semiconductor layer 40, the active layer 52, and the second conductive-type semiconductor layer 53 may be defined as a light emitting structure 50. The light emitting structure 50 may have one of an N-P-N junction structure, a P-N junction structure, and a P-N-P junction structure as well as an N-P junction structure. In other words, the first and second conductive types are P and N types, respectively, and an N-type semiconductor layer or a P-type semiconductor layer may be stacked on the second compound semiconductor layer 40.

Hereinafter, the method for manufacturing a semiconductor light emitting device according to the embodiment will be described. The first compound semiconductor layer 11 is etched by using the first particles 12 as a mask, so that the semiconductor rods 20 are formed. In other words, in the method for manufacturing the semiconductor light emitting device according to the embodiment, the first compound semiconductor layer 11 is patterned without using a mask formed through a photolithography process, thereby forming the semiconductor rods 20.

Therefore, when comparing with an epitaxial lateral overgrowth (ELO) scheme employing an existing photolithography process or a scheme of employing a sapphire substrate finely patterned through the photolithography process, a high-quality semiconductor device can be easily manufactured through the method for manufacturing the semiconductor device according to the embodiment. In other words, the manufacturing process for the semiconductor device according to the embodiment is easily controlled, and performed at low cost with high reproducibility and high product yield.

The semiconductor device according to the embodiment includes the second particles 30. The second particles 30 effectively reflect in an upward direction light output from the active layer 52. In other words, the light efficiency of the semiconductor light emitting device according to the embodiment can be improved due to a difference in a refractive index between the second compound semiconductor layer 40 and the second particles 30.

The light emitted from the active layer 52 is reflected in an upward direction from an interfacial surface between the second compound semiconductor layer 40 and the second particles 30. Accordingly, the light efficiency of the semiconductor light emitting device according to the embodiment can be further improved.

Since the second compound semiconductor layer 40 slightly makes contact with the semiconductor rods 30, defects caused by crystallographic difference between the second compound semiconductor layer 40 and the semiconductor rods 30 can be reduced. Similarly, defects caused by crystallographic difference between the support substrate 10 and the semiconductor rods 30 can be reduced.

Accordingly, the semiconductor rods 30 may perform a buffer function to compensate for the crystallographic difference between the second compound semiconductor layer 40 and the support substrate 10.

Therefore, the semiconductor light emitting device according to the embodiment can reduce defects caused by crystallographic difference between layers.

Any reference in this specification to "one embodiment", "on embodiment", "example embodiment", etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

### Industrial Applicability

The semiconductor light emitting device according to the embodiment can be used in the fields of a semiconductor, a display, an illumination, and the like.

## Claims

1. A light emitting diode device comprising:
a substrate (10);
a plurality of rods (20) being spaced apart on the substrate (10);
a plurality of particles (30) disposed between the rods (20) and on the substrate (10);
a first semiconductor layer (40) disposed on the rods (20); and
**characterized by** a porous layer interposed between the first semiconductor layer (40) and the particles (30).

2. The light emitting diode device of claim 1, further comprising a second
semiconductor layer (11) interposed between the rods (20) and the substrate (10) while being integrally formed with the rods (20).

3. The light emitting diode device of claim 1, wherein the rods (20) are randomly
arranged.

4. The light emitting diode device of claim 1, wherein the particles (30) include SiO₂,
Al₂O₃, TiO₂, ZrO₂, CuO, Y₂O₃-ZrO₂, Ta₂O₅, PZT, Nb₂O₅, FeSO₄, Fe₂O₄, Fe₂O₃, Na₂SO₄, GeO₂ or CdS.

5. The light emitting diode device of claim 1, wherein the rods (20) have a diameter of
about 0.5µm to about 5µm, an interval between the rods (20) is in a range of about 0 to about 10µm, and the particles (30) have a diameter in a range of about 10nm to about 500nm.

6. The light emitting diode device
of claim 1, further comprising:
a second conductive-type semiconductor layer (53) disposed over the first semiconductor layer (40); and
an active layer (52) interposed between the first semiconductor layer (40) and the second conductive-type semiconductor layer (53),
wherein 'the first semiconductor layer (40) includes first conductive-type impurities, and the second conductive-type semiconductor layer (53) includes second conductive-type impurities.

7. The light emitting diode device of claim 1, wherein the rods (20) are integrally formed with the substrate (10).

8. The light emitting diode device of claim 1, wherein the first semiconductor layer (40) includes a material identical to a material of the rods (20).

9. The light emitting diode device of claim 1, wherein a diameter of the rods (20) is
greater than a diameter of the particles (30).

10. A light emitting diode device comprising:
a substrate (10);
a plurality of rods (20) being spaced apart on the substrate (10);
a plurality of particles (30) disposed between the rods (20) and on the substrate (10);
a first conductive-type semiconductor layer (40) disposed on the particles (30) and the rods (20);
an active layer (52) disposed on the first conductive-type semiconductor layer (40); and
a second conductive-type semiconductor layer (53) disposed on the active layer (52); and **characterized by** a porous layer interposed between the first conductive-type semiconductor layer (40) and the particles (30).

11. The light emitting diode device of claim 10, wherein the rods (20) are randomly
arranged on the substrate (10).

12. The light emitting diode device of claim 10, further comprising:
a first electrode (61) making contact with the first conductive-type semiconductor layer (40); and
a second electrode (62) making contact with the second conductive-type semiconductor layer (53).

13. The light emitting diode device of claim 10, wherein the rods (20) and the first and
second conductive-type semiconductor layers (40, 53) include GaN, InN, AIN, InGaN, AlGaN, AlInN, or AlInGaN.

14. The light emitting diode device of claim 10, wherein the first conductive-type semiconductor layer (11) includes Si, Ge, Sn, Se, or Te as a dopant, and the second conductive-type semiconductor layer (53) includes Mg, Zn, Ca, Sr or Ba as a dopant.

15. The light emitting diode device of claim 10, wherein a height of the particles (30)
is lower than a height of the rods (20).

16. A method for manufacturing a light emitting diode device, the method comprising:
preparing a substrate (10);
disposing a plurality of first particles (12) on the substrate (10); and
forming a plurality of rods (20) being spaced apart on the substrate by etching a portion of the substrate (10) by using the first particles (12) as an etch mask;
disposing second particles (30) between the rods (20); and
forming a first semiconductor layer (40) on the rods (20) and **characterized by** forming a porous layer interposed between the first semiconductor layer (40) and the second particles (30).

17. The method of claim 16, wherein the first particles (12) have a larger diameter than the second particles (30).

18. The method of claim 16, wherein the first semiconductor layer (40) is grown from a top surface of the rods (20) when the first semiconductor layer (40) is formed.

19. The method of claim 16, wherein a second semiconductor layer (11) is formed on a support substrate when the substrate (10) is prepared, and the rods (20) are formed by etching a portion of the second semiconductor layer (11).

20. The method of claim 19, wherein the rods (20) are formed by etching the second semiconductor layer (11) at a height lower than a thickness of the second semiconductor layer.

21. The method of claim 16, wherein the first particles (12) are randomly arranged on the substrate (10).

## Patentansprüche

1. Leuchtdioden-Bauelement aufweisend:
ein Substrat (10);
mehrere Stäbchen (20), die voneinander beabstandet auf dem Substrat (10) angeordnet sind;
mehrere Partikel (30), die zwischen den Stäbchen (20) und auf dem Substrat (10) angeordnet sind;
eine erste Halbleiterschicht (40), die auf den Stäbchen (20) angeordnet ist; und
**gekennzeichnet durch** eine poröse Schicht, die zwischen der ersten Halbleiterschicht (40) und den Partikeln (30) eingefügt ist.

2. Leuchtdioden-Bauelement nach Anspruch 1, ferner aufweisend eine zweite Halbleiterschicht (11), die zwischen den Stäbchen (20) und dem Substrat (10) eingefügt ist und einstückig mit den Stäbchen (20) ausgebildet ist.

3. Leuchtdioden-Bauelement nach Anspruch 1, wobei die Stäbchen (20) wahllos angeordnet sind.

4. Leuchtdioden-Bauelement nach Anspruch 1, wobei die Partikel (30) SiO₂, Al₂O₃, TiO₂, ZrO₂, CuO, Y₂O₃-ZrO₂, Ta₂O₅, PZT, Nb₂O₅, FeSO₄, Fe₂O₄, Fe₂O₃, Na₂SO₄, GeO₂ oder CdS beinhalten.

5. Leuchtdioden-Bauelement nach Anspruch 1, wobei die Stäbchen (20) einen Durchmesser von etwa 0,5 µm bis etwa 5 µm aufweisen, ein Abstand zwischen den Stäbchen (20) sich in einem Bereich von etwa 0 bis etwa 10 µm befindet und die Partikel (30) einen Durchmesser in einem Bereich von etwa 10 nm bis etwa 500 nm aufweisen.

6. Leuchtdioden-Bauelement nach Anspruch 1, ferner aufweisend:
eine zweite, leitfähige Halbleiterschicht (53), die über der ersten Halbleiterschicht (40) angeordnet ist; und
eine aktive Schicht (52), die zwischen der ersten Halbleiterschicht (40) und der zweiten, leitfähigen Halbleiterschicht (53) eingefügt ist,
wobei die erste Halbleiterschicht (40) erste leitfähige Verunreinigungen beinhaltet und die zweite, leitfähige Halbleiterschicht (53) zweite leitfähige Verunreinigungen beinhaltet.

7. Leuchtdioden-Bauelement nach Anspruch 1, wobei die Stäbchen (20) einstückig mit dem Substrat (10) ausgebildet sind.

8. Leuchtdioden-Bauelement nach Anspruch 1, wobei die erste Halbleiterschicht (40) ein Material beinhaltet, das identisch mit einem Material der Stäbchen (20) ist.

9. Leuchtdioden-Bauelement nach Anspruch 1, wobei ein Durchmesser der Stäbchen (20) größer ist als ein Durchmesser der Partikel (30).

10. Leuchtdioden-Bauelement aufweisend:
ein Substrat (10);
mehrere Stäbchen (20), die voneinander beabstandet auf dem Substrat (10) angeordnet sind;
eine Mehrzahl von Partikel (30), die zwischen den Stäbchen (20) und auf dem Substrat (10) angeordnet sind;
eine erste leitfähige Halbleiterschicht (40), die auf den Partikeln (30) und den Stäbchen (20) angeordnet ist;
eine aktive Schicht (52), die auf der ersten leitfähigen Halbleiterschicht (40) angeordnet ist; und
eine zweite leitfähige Halbleiterschicht (53), die auf der aktiven Schicht (52) angeordnet ist; und
**gekennzeichnet durch** eine poröse Schicht, die zwischen der ersten leitfähigen Halbleiterschicht (40) und den Partikeln (30) eingefügt ist.

11. Leuchtdioden-Bauelement nach Anspruch 10, wobei die Stäbchen (20) wahllos auf dem Substrat (10) angeordnet sind.

12. Leuchtdioden-Bauelement nach Anspruch 10, ferner aufweisend:
eine erste Elektrode (61), die einen Kontakt zu der ersten leitfähigen Halbleiterschicht (40) herstellt; und
eine zweite Elektrode (62), die einen Kontakt zu der zweiten leitfähigen Halbleiterschicht (53) herstellt.

13. Leuchtdioden-Bauelement nach Anspruch 10, wobei die Stäbchen (20) und die erste und zweite leitfähige Halbleiterschicht (40, 53) GaN, InN, AIN, InGaN, AlGaN, AlInN oder AlInGaN beinhalten.

14. Leuchtdioden-Bauelement nach Anspruch 10, wobei die erste leitfähige Halbleiterschicht (11) Si, Ge, Sn, Se oder Te als einen Dotierstoff beinhaltet und die zweite leitfähige Halbleiterschicht (53) Mg, Zn, Ca, Sr oder Ba als einen Dotierstoff beinhaltet.

15. Leuchtdioden-Bauelement nach Anspruch 10, wobei eine Höhe der Partikel (30) geringer ist als eine Höhe der Stäbchen (20).

16. Verfahren zur Herstellung eines Leuchtdioden-Bauelements, wobei das Verfahren aufweist:
Anfertigen eines Substrats (10);
Anordnen mehrerer erster Partikel (12) auf dem Substrat (10); und
Bilden einer Mehrzahl von Stäbchen (20), die voneinander beabstandet auf dem Substrat angeordnet sind, durch Ätzen eines Teils des Substrats (10), indem die ersten Partikel (12) als eine Ätzmaske verwendet werden;
Anordnen zweiter Partikel (30) zwischen den Stäbchen (20); und
Bilden einer ersten Halbleiterschicht (40) auf den Stäbchen (20) und
**gekennzeichnet durch** Bilden einer porösen Schicht, die zwischen der ersten Halbleiterschicht (40) und den zweiten Partikeln (30) eingefügt ist.

17. Verfahren nach Anspruch 16, wobei die ersten Partikel (12) einen größeren Durchmesser aufweisen als die zweiten Partikel (30).

18. Verfahren nach Anspruch 16, wobei die erste Halbleiterschicht (40) ausgehend von einer Oberseite der Stäbchen (20) gezüchtet wird, wenn die erste Halbleiterschicht (40) gebildet wird.

19. Verfahren nach Anspruch 16, wobei eine zweite Halbleiterschicht (11) auf einem Trägersubstrat gebildet wird, wenn das Substrat (10) angefertigt wird, und die Stäbchen (20) durch Ätzen eines Teils der zweiten Halbleiterschicht (11) gebildet werden.

20. Verfahren nach Anspruch 19, wobei die Stäbchen (20) durch Ätzen der zweiten Halbleiterschicht (11) auf eine Höhe gebildet werden, die geringer ist als eine Dicke der zweiten Halbleiterschicht.

21. Verfahren nach Anspruch 16, wobei die ersten Partikel (12) wahllos auf dem Substrat (10) angeordnet werden.

## Revendications

1. Dispositif à diode électroluminescente comprenant :
un substrat (10) ;
une pluralité de tiges (20) étant espacées sur le substrat (10) ;
une pluralité de particules (30) disposées entre les tiges (20) et sur le substrat (10) ;
une première couche semi-conductrice (40) disposée sur les tiges (20) ; et
**caractérisée par** une couche poreuse interposée entre la première couche semi-conductrice (40) et les particules (30).

2. Dispositif à diode électroluminescente selon la revendication 1, comprenant en outre une seconde couche semi-conductrice (11) interposée entre les tiges (20) et le substrat (10) tout en étant intégralement formée avec les tiges (20).

3. Dispositif à diode électroluminescente selon la revendication 1, où les tiges (20) sont disposées de manière aléatoire.

4. Dispositif à diode électroluminescente selon la revendication 1, où les particules (30) incluent les composés SiO₂, Al₂O₃, TiO₂, ZrO₂, CuO, Y₂O₃-ZrO₂, Ta₂O₅, PZT, Nb₂O₅, FeSO₄, Fe₂O₄, Fe₂O₃, Na₂SO₄, GeO₂ ou CdS.

5. Dispositif à diode électroluminescente selon la revendication 1, où les tiges (20) ont un diamètre d'environ 0,5 µm à environ 5 µm, un intervalle entre les tiges (20) est de l'ordre d'environ 0 à environ 10 µm, et les particules (30) ont un diamètre de l'ordre d'environ 10 nm à environ 500 nm.

6. Dispositif à diode électroluminescente selon la revendication 1, comprenant en outre :
une couche semi-conductrice d'un second type de conductivité (53) disposée pardessus la première couche semi-conductrice (40) ; et
une couche active (52) interposée entre la première couche semi-conductrice (40) et la couche semi-conductrice d'un second type de conductivité (53),
où la première couche semi-conductrice (40) inclut des impuretés d'un premier type de conductivité, et la couche semi-conductrice d'un second type de conductivité (53) inclut des impuretés d'un type de conductivité.

7. Dispositif à diode électroluminescente selon la revendication 1, où les tiges (20) sont intégralement formées avec le substrat (10).

8. Dispositif à diode électroluminescente selon la revendication 1, où la première couche semi-conductrice (40) inclut un matériau identique au matériau des tiges (20).

9. Dispositif à diode électroluminescente selon la revendication 1, où un diamètre des tiges (20) est supérieur à un diamètre des particules (30).

10. Dispositif à diode électroluminescente comprenant :
un substrat (10) ;
une pluralité de tiges (20) étant espacées sur le substrat (10) ;
une pluralité de particules (30) disposées entre les tiges (20) et sur le substrat (10) ;
une couche semi-conductrice (40) d'un premier type de conductivité disposée sur les particules (30) et les tiges (20) ;
une couche active (52) disposée sur la couche semi-conductrice d'un premier type de conductivité (40) ; et
une couche semi-conductrice d'un second type de conductivité (53) disposée sur la couche active (52) ; et **caractérisée par** une couche poreuse interposée entre la couche semi-conductrice d'un premier type de conductivité (40) et les particules (30).

11. Dispositif à diode électroluminescente selon la revendication 10, où les tiges (20) sont disposées de manière aléatoire sur le substrat (10).

12. Dispositif à diode électroluminescente selon la revendication 10, comprenant en outre :
une première électrode (61) en contact avec la couche semi-conductrice d'un premier type de conductivité (40) ; et
une seconde électrode (62) en contact avec la couche semi-conductrice d'un second type de conductivité (53).

13. Dispositif à diode électroluminescente selon la revendication 10, où les tiges (20) et les couches semi-conductrices d'un premier et d'un second type de conductivité (40, 53) incluent GaN, InN, AlN, InGaN, AlGaN, AlInN, ou AlInGaN.

14. Dispositif à diode électroluminescente selon la revendication 10, où la couche semi-conductrice d'un premier type de conductivité (11) inclut Si, Ge, Sn, Se, ou Te comme dopant, et la couche semi-conductrice d'un second type de conductivité (53) inclut Mg, Zn, Ca, Sr ou Ba comme dopant.

15. Dispositif à diode électroluminescente selon la revendication 10, où une hauteur des particules (30) est inférieure à une hauteur des tiges (20).

16. Procédé pour fabriquer un dispositif à diode électroluminescente, le procédé comprenant les étapes consistant à :
préparer un substrat (10) ;
disposer une pluralité de premières particules (12) sur le substrat (10) ; et
former une pluralité de tiges (20) étant espacées sur le substrat en gravant une partie du substrat (10) en utilisant les premières particules (12) comme masque d'attaque ;
disposer de secondes particules (30) entre les tiges (20) ; et
former une première couche semi-conductrice (40) sur les tiges (20) et **caractérisée par** la formation d'une couche poreuse interposée entre la première couche semi-conductrice (40) et les secondes particules (30).

17. Procédé selon la revendication 16, où les premières particules (12) ont un diamètre supérieur aux secondes particules (30).

18. Procédé selon la revendication 16, où la première couche semi-conductrice (40) est produite à partir d'une surface supérieure des tiges (20) lorsque la première couche semi-conductrice (40) est formée.

19. Procédé selon la revendication 16, où une seconde couche semi-conductrice (11) est formée sur un substrat de support lorsque le substrat (10) est préparé, et les tiges (20) sont formées par gravure d'une partie de la seconde couche semi-conductrice (11).

20. Procédé selon la revendication 19, où les tiges (20) sont formées en gravant la seconde couche semi-conductrice (11) à une hauteur inférieure à l'épaisseur de la seconde couche semi-conductrice.

21. Procédé selon la revendication 16, où les premières particules (12) sont disposées de manière aléatoire sur le substrat (10).
